(19)

Europäisches
Patentamt
European
Patent Office
Office européen
des brevets

(11) **EP 1 997 938 A2**

(12) **EUROPEAN PATENT APPLICATION**

(43) Date of publication:
**03.12.2008 Bulletin 2008/49**

(51) Int Cl.:
***C23C 28/04*** (2006.01)     ***C23C 30/00*** (2006.01)
***B23B 27/14*** (2006.01)

(21) Application number: **08156081.5**

(22) Date of filing: **13.05.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority: **01.06.2007   SE 0701321**

(71) Applicant: **Sandvik Intellectual Property AB
81181 Sandviken (SE)**

(72) Inventors:
• **Sundström, Rickard
SE-138 36 Älta (SE)**
• **Kusoffsky, Alexandra
SE-181 60 Lidingö (SE)**
• **Pettersson, Marie
SE-125 70 Älvsjö (SE)**
• **Lundquist, Anders
SE-136 59 Haninge (SE)**

(74) Representative: **Hägglöf, Henrik
Sandvik Intellectual Property AB
811 81 Sandviken (SE)**

(54) **Coated cutting tool insert**

(57)     The present invention discloses a coated cutting tool insert particularly useful for dry and wet machining, preferably milling, in un-, low- and high alloyed steels and cast iron, with or without raw surface zones. The insert is characterized by a WC-TaC-NbC-Co cemented carbide with a W alloyed Co-binder phase and a coating including an innermost layer of $TiC_xN_yO_z$ with columnar grains and a top layer at least on the rake face of a smooth $\alpha$-$Al_2O_3$.

**Fig 1**

EP 1 997 938 A2

**Description**

The present invention relates to a coated cemented carbide cutting tool insert particularly useful for dry and wet machining, preferably milling, of un-, low- and highly alloyed steels and cast irons, with raw surfaces such as cast skin, forged skin, hot or cold rolled skin or premachined surfaces.

When machining, the cemented carbide cutting edge will be subjected to wear. The wear can be characterised by different mechanisms, such as chemical wear, abrasive wear, adhesive wear and edge chipping caused by cracks formed along the cutting edge, the so called comb cracks. Under severe cutting conditions bulk and edge line breakages commonly occur. Depending on the work piece materials and cutting conditions different properties of the cutting insert are required. For example, when cutting steel components with raw surface zones or cutting under other difficult conditions the coated cemented carbide insert must be based on a tough carbide substrate and have a coating with excellent adhesion. When machining low alloyed steels and cast irons using high cutting speed and large radial depth of cut the chemical wear is generally the dominating wear type. Here, generally 7-14 $\mu$m thick CVD-coatings are preferred.

Measures can be taken to improve or optimize cutting performance with respect to a specific wear type. However, very often such measures will have a negative effect on other wear properties.

The influence of some possible measures is given below:

1.) Comb crack formation can be reduced by lowering the binder phase content. However, low binder content will lower the toughness properties of the cutting inserts which is far from desirable.

2.) Improved chemical wear can be obtained by increasing the coating thickness. However, thick coatings increase the risk for flaking and will also lower the resistance to adhesive wear.

3.) Machining at high cutting speeds and at other conditions leading to high cutting edge temperatures require a cemented carbide with higher amounts of cubic carbides (solid solution of WC-TiC-TaC-NbC), but such carbides will promote comb crack formation.

4.) Improved toughness can be obtained by increasing the cobalt binder content. However, high cobalt content decreases the resistance to plastic deformation.

Commercial cemented carbide grades are typically positioned and optimized with respect to one or a few of the mentioned wear types and hence to a specific cutting application area.

US 6,062,776 discloses a coated cutting tool insert particularly useful for milling in low and medium alloyed steel with or without raw surface zones during wet or dry conditions. The insert is characterized by WC-Co cemented carbide with a low content of cubic carbides and a highly W-alloyed binder phase, a coating including an innermost layer of $TiC_xN_yO_z$ with columnar grains and a layer of $\kappa$-$Al_2O_3$ with a top layer of TiN.

US 6,406,224 discloses a coated cutting tool insert also particularly useful for milling of alloyed steel with or without abrasive surface zones at high cutting speeds. The coated cutting tool insert consists of a cemented carbide body with a composition of 7.1-7.9 wt% Co, 0.2-1.8 wt% cubic carbides of the metals Ta, Nb and Ti and balance WC. The insert is coated with an innermost layer of $TiC_xN_yO_z$ with columnar grains and a layer of $\kappa$-$Al_2O_3$ with a top layer of TiN.

EP-A-736615 discloses a coated cutting insert particularly useful for dry milling of grey cast iron. The insert is characterized by having a straight WC-Co cemented carbide substrate and a coating consisting of a layer of $TiC_xN_yO_z$ with columnar grains and a top layer of fine grained textured $\alpha$-$Al_2O_3$.

EP-A-1696051 discloses a coated cutting tool insert suitable for machining of metals by turning, milling, drilling or by similar chip forming machining methods. The tool insert is particularly useful for interrupted toughness demanding cutting operations.

US 6,200,671 disclose a coated turning insert particularly useful for turning in stainless steel. The insert is characterised by WC-Co-based cemented carbide substrate having a highly W-alloyed Co-binder phase and a coating including an innermost layer of $TiC_xN_yO_z$ with columnar grains and a top layer of TiN and an inner layer of fine grained $\kappa$-$Al_2O_3$.

The inventors have developed an improved cutting tool insert, preferably for milling. The combined features are: a specific cemented carbide composition, a certain WC grain size, alloyed binder phase, an inner coating consisting of a number of defined layers and a smooth top rake face layer of $\alpha$-$Al_2O_3$.

The insert has improved cutting performance in un-, low- and highly alloyed steel, with or without raw surface zones preferably under stable conditions in both dry and wet machining. The disclosed cutting tool insert also works well in cast irons. The cutting tool shows improved cutting properties compared to prior art inserts with respect to many of the wear types earlier mentioned. In particular chemical resistance and comb crack resistance have been improved.

Fig. 1 shows a light optical micrograph in 50x magnification of the crater wear pattern of a sample insert according to the present invention and Fig. 2 an insert according to prior art, when subjected to face milling test.

Fig. 3 shows a light optical micrograph in 50x magnification of the difference in edge line toughness of a sample insert according to the present invention and Fig. 4 of an insert according to prior art, when subjected to a face milling test.

The cutting tool insert according to the invention comprises a cemented carbide body with a W alloyed Co-binder phase, a well balanced chemical composition and a well selected grain size of the WC, and a coating consisting of a columnar $TiC_xN_yO_z$-inner layer followed by a smooth $\alpha$-$Al_2O_3$-top layer. A TiN-layer is preferably the top layer at the clearance faces of the insert.

According to the present invention, a coated cutting tool insert is provided comprising a cemented carbide body with a composition of 8.1-9.3 wt% Co, preferably 8.3-9.1 wt% Co, most preferably 8.4-9.0 wt% Co, and 1.00-1.45 wt% TaC, preferably 1.18-1.28 wt% TaC, and 0.10-0.50 wt% NbC, preferably 0.25-0.35 wt% NbC, and balance WC. The cemented carbide body may also contain smaller amounts of other elements, but then at a level corresponding to a technical impurity. The coercivity is in the range 14.9-16.7 kA/m, preferably 15.3-16.3 kA/m.

The cobalt binder phase is alloyed with a certain amount of W giving the invented cemented carbide cutting insert its desired properties. W in the binder phase influences the magnetic properties of cobalt and can hence be related to a value CW-ratio, defined as

$$CW\text{-}ratio= magnetic\text{-}\% \ Co \ / \ wt\text{-}\% \ Co$$

 where magnetic-% Co is the weight percentage of magnetic Co and wt-% Co is the weight percentage of Co in the cemented carbide.

The CW-ratio varies between 1 and about 0.75 dependent on the degree of alloying. A lower CW-ratio corresponds to higher W contents and CW-ratio =1 corresponds practically to an absence of W in the binder phase.

It has been found that improved cutting performance is achieved if the cemented carbide has a CW-ratio of 0.80- <1.00, preferably 0.81-0.90, most preferably 0.82-0.88.

The cemented carbide may also contain small amounts, <1 volume %, of $\eta$-phase ($M_6C$), without any detrimental effects. From the specified CW-ratios (<1) it also follows that no free graphite is allowed in the cemented carbide body according to the present invention.

The cemented carbide insert is at least partly coated with a 7.5-13.5 $\mu$m thick coating including at least three layers of $TiC_xN_yO_z$. The three layers form an inner coating with an $\alpha$-$Al_2O_3$-layer as the outer layer at least on the rake face. The $TiC_xN_yO_z$-layers, having a total thickness of 3.0-8.0 $\mu$m, comprise:

a first $TiC_xN_yO_z$ layer adjacent to the cemented carbide having a composition of x+y=1, x>= 0, preferably x < 0.2 and z=0;
a second $TiC_xN_yO_z$ layer having a composition of x>0.4, y>0.4 and 0=<z< 0.1, preferably z=0; and
a third $TiC_xN_yO_z$ bonding layer with needle shaped grains adjacent to the $\alpha$-$Al_2O_3$-layer having a composition of x+y+z>=1 and z>0, preferably z>0.2 and x+y+z=1.

The outer $\alpha$-$Al_2O_3$-layer has a thickness of 2.0-6.0 $\mu$m with flattened grains on the surfaces that have been subjected to a blasting treatment.

In one embodiment an additional 0.1-2.3 $\mu$m, preferably 0.1-1 $\mu$m, coloured layer is present on top of the $\alpha$-$Al_2O_3$-layer preferably of TiN, Ti(C,N), TiC, ZrN or HfN.

The present invention also relates to a method of making a coated cutting tool insert by powder metallurgical technique, wet milling of powders forming hard constituents and binder phase, compacting the milled mixture to bodies of desired shape and size and sintering, comprising a cemented carbide body with a composition of 8.1-9.3 wt% Co, preferably 8.3-9.1 wt% Co, most preferably 8.4-9.0 wt% Co, and 1.00-1.45 wt% TaC, preferably 1.18-1.28 wt% TaC, and 0.10-0.50 wt% NbC, preferably 0.25-0.35 wt% NbC, and balance WC. The cemented carbide body may also contain smaller amounts of other elements, but then on a level corresponding to a technical impurity. The milling and sintering conditions are chosen to obtain an as-sintered structure with the coercivity in the range 14.9-16.7 kA/m, preferably within 15.3-16.3 kA/m, and a CW-ratio of 0.80-<1.00, preferably 0.81-0.90, most preferably 0.82-0.88.

The cemented carbide insert body is at least partly coated with a 7.5-13.5 $\mu$m thick coating including at least three layers of $TiC_xN_yO_z$ forming an inner coating with a blasted $\alpha$-$Al_2O_3$-layer as the outer layer at least on the rake face. The $TiC_xN_yO_z$-layers, having a total thickness of 3.0-8.0 $\mu$m, comprise:

- a first $TiC_xN_yO_z$ layer adjacent to the cemented carbide having a composition of x+y=1, x>= 0, preferably x < 0.2 and z=0 using known CVD method using a reaction mixture consisting of $TiCl_4$, H2 and N2;
- a second $TiC_xN_yO_z$ layer having a composition of x>0.4, y>0.4 and 0=< z < 0.1, preferably z=0, by using the well-known MTCVD-technique, temperature 885-850 °C and $CH_3CN$ as the carbon/nitrogen source and optionally CO and/or $CO_2$; and
- a third $TiC_xN_yO_z$ bonding layer with needle shaped grains adjacent to the $\alpha$-$Al_2O_3$-layer having a composition of x+y+z>=1 and z>0, preferably z>0.2 and x+y+z=1 using known CVD method using a reaction mixture consisting of $TiCl_4$, $H_2$, CO and/or $CO_2$ and optionally $N_2$,

The $\alpha$-$Al_2O_3$-layer with a thickness of 2.0-6.0 $\mu$m is deposited by using known CVD-technique and subjecting the insert to a blasting treatment at least on the rake face.

In one embodiment an additional 0.1-2.3 $\mu$m, preferably 0.1-1 $\mu$m, coloured layer is deposited on top of the $\alpha$-$Al_2O_3$-layer preferably of TiN, Ti(C,N), TiC, ZrN or HfN preferably using CVD technique prior to the blasting treatment.

The present invention also relates to the use of an insert according to above for dry and wet machining, preferably milling, of unalloyed, low and high alloyed steels and cast irons, with raw surfaces such as cast skin, forged skin, hot or cold rolled skin or pre-machined surfaces at cutting speeds and feed rates according to following table:

Milling with 90° entering angle:

Cutting speed: 25-400 m/min, preferably 150-300 m/min and feed rate: 0.04-0.4 mm/tooth

Face milling (45-75° entering angle):

Cutting speed: 25-600 m/min, preferably 200-400 m/min and feed rate: 0.05-0.7 mm/tooth

High feed and round insert milling concepts:

Cutting speed: 25-600 m/min and feed rate: 0.05-3.0 mm/tooth, preferably 0.3-1.8 mm/tooth.

Example 1. (Invention A)

Cemented carbide milling inserts in the following styles R390-11T308M-PM, R390-170408M-PM, R245-12T3M-PM, R300-1648M-PH and R300-1240M-PH having a composition of 8.7 wt-% Co, 1.25 wt-% TaC, 0.28 wt-% NbC and balance WC and with a coercivity of 15.5 kA/m, corresponding to a WC grain size of about 1.3 $\mu$m, and a CW-ratio of 0.84 as measured in the FÖRSTER KOERZIMAT CS 1.096 from Foerster Instruments Inc. were prepared. The inserts were coated as follows:

a first layer of 0.5 $\mu$m $TiC_xN_yO_z$ with a composition of about x=0.05, y=0.95 and z=0 using known CVD method using a reaction mixture consisting of $TiCl_4$, $H_2$ and $N_2$,

a second layer of 6 $\mu$m columnar $TiC_xN_yO_z$ with a composition of about x=0.55, y=0.45 and z=0 by using the well-known MTCVD-technique, temperature 885-850 °C and $CH_3CN$ as the carbon/nitrogen source; and

a third, bonding layer of 0.5 $\mu$m $TiC_xN_yO_z$. The grains of this third layer were needle shaped and the composition was about x=0.5, y=0 and z=0.5; and

a fourth layer consisting of 4 $\mu$m $\alpha$-$Al_2O_3$ and finally a top layer of about 2 $\mu$m TiN was deposited by using known CVD-technique. XRD-measurements confirmed that the $Al_2O_3$-layer consisted to 100 % of the $\alpha$-phase.

After the coating cycle the top side (rake face) of the inserts was subjected to intense wet blasting with a slurry consisting of $Al_2O_3$ grits and water. The blasting treatment removed the top TiN-layer on the rake face exposing a smooth $\alpha$-$Al_2O_3$ with most grains flattened.

Example 2 (prior art B)

Cemented carbide milling inserts in the following styles R390-11T308M-PM, R390-170408M-PM, R245-12T3M-PM, R300-1648M-PH and R300-1240M-PH with a composition of 7.6 wt-% Co, 1.25 wt-% TaC, 0.28 wt-% NbC and balance WC and with a coercivity of 14.7 kA/m, corresponding to a WC grain size of about 1.5 $\mu$m, and a CW ratio of 0.91 as measured in the FÖRSTER KOERZIMAT CS 1.096 from Foerster Instruments Inc. were prepared. The inserts were coated as follows:

a first layer of 0.5 $\mu$m equiaxed $TiC_xN_y$-layer (with a high nitrogen content corresponding to an estimated x=0.95 and y=0.05) followed by a

4 $\mu$m thick Ti(C,N)-layer, with columnar grains by using MTCVD-technique at a temperature 885-850 °C and with $CH_3CN$ as the carbon/nitrogen source. In subsequent steps during the same coating cycle, a 1.0 $\mu$m thick layer of $Al_2O_3$ was deposited using a temperature 970 °C and a concentration of $H_2S$ dopant of 0.4 % as disclosed in EP-A-523 021. A thin, 0.5 $\mu$m, layer of TiN was deposited on top according to known CVD-technique. XRD-measurement

showed that the $Al_2O_3$-layer consisted of 100 % K-phase.

Example 3

Inserts of the different styles from Examples 1 and 2 were compared in cutting tests.

| **Operation 1:** | Face milling, Coromill 245 |
|---|---|
| Work-piece: | Plate |
| Material: | Unalloyed steel, 200HB |
| Cutting speed: | 350 m/min |
| Feed rate/tooth: | 0.45 mm/tooth |
| Axial depth of cut: | 2.0 mm |
| Radial depth of cut: | 95 mm |
| Insert-style: | R245-12T3M-PH |
| Cutter diameter: | 250 mm |
| Note: One insert in the cutter, dry machining. | |

Tool-life criterion was flank wear and chemical wear. A combination of better wear resistance and better resistance to chemical wear gave a considerable increase in tool life.

| Results: | Tool-life, minutes in cut |
|---|---|
| Invention A: | 36 |
| Prior art B: | 19 |

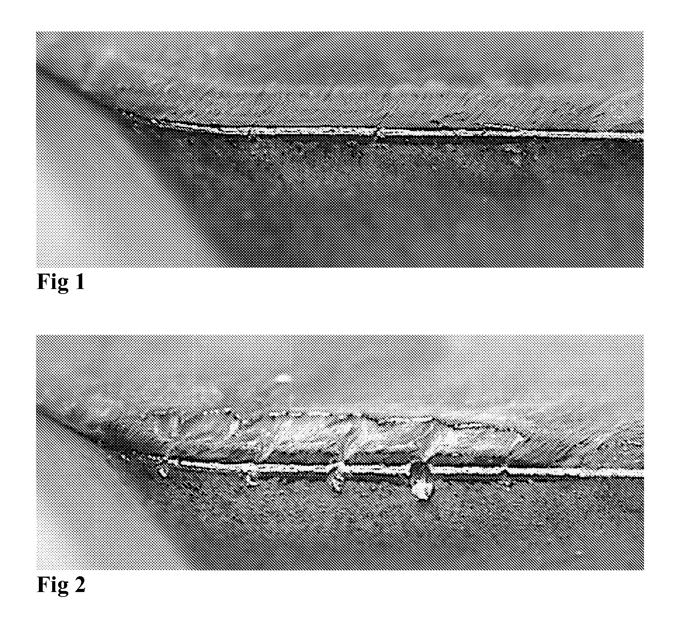

The improved resistance to chemical wear is clearly shown for the present invention A in fig 1 compared to prior art B in Fig 2. The edge line is intact in the present invention A, fig. 1 whereas in the prior art B, fig 2 a crater with comb cracks has developed.

| **Operation 2:** | Face milling, Coromill 245 |
|---|---|
| Work-piece: | Plate |
| Material: | Unalloyed steel, 200HB |
| Cutting speed: | 300 m/min |
| Feed rate/tooth: | 0.35 mm/tooth |
| Axial depth of cut: | 1.0-3,5 mm |
| Radial depth of cut: | 120 mm |
| Insert-style: | R245-12T3M-PH |
| Cutter diameter: | 160 mm |
| Note: Ten inserts in the cutter, dry machining. | |

Tool-life criterion was flank wear and edge line toughness. A combination of better wear resistance and better edge line toughness gave a considerable increase in tool life.

| Results: | Tool-life: minutes in cut |
|---|---|
| Invention A: | 70 |
| Prior art B: | 31 |

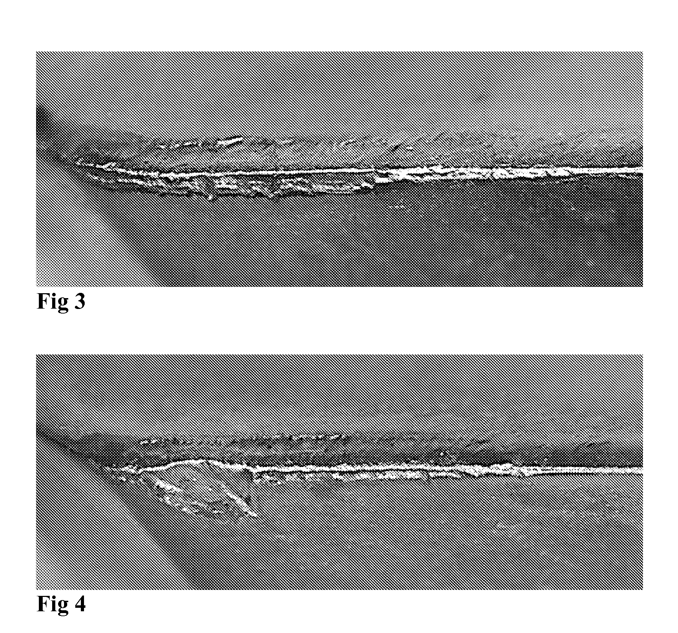

The improved edge line toughness is clearly shown for the present invention A in fig 3 compared to prior art B in Fig 4. The edge line is intact in the present invention A, fig. 3 whereas in the prior art B, fig 4 comb cracks have developed resulting in edge line breakage.

| **Operation 3:** | Face milling, Coromill 210 |
|---|---|
| Work-piece: | Plate |
| Material: | High-alloyed steel, 240HB |

(continued)

| Cutting speed: | 142 m/min |
|---|---|
| Feed rate/tooth: | 1.33 mm/tooth |
| Axial depth of cut: | 1.5 mm |
| Radial depth of cut: | 76 mm |
| Insert-style: | R210-140512M-PM |
| Cutter diameter: | 100 mm |

Note: Seven inserts in the cutter, dry machining.

Tool-life criterion was flank wear. A combination of better abrasive wear resistance gave a considerable increase in tool life.

| Results: | Tool-life, minutes in cut |
|---|---|
| Invention A: | 90 |
| Prior art B: | 31 |

| Operation 4: | Face milling, Coromill 245 |
|---|---|
| Work-piece: | Plate |
| Material: | High-alloyed steel, 230HB |
| Cutting speed: | 350 m/min |
| Feed rate/tooth: | 0.40 mm/tooth |
| Axial depth of cut: | 2.5 mm |
| Radial depth of cut: | 170 mm |
| Insert-style: | R245-12T3M-PH |
| Cutter diameter: | 200 mm |

Note: 12 inserts in the cutter, dry machining.

Edge line toughness, chipping behaviour on insert was the tool life criterion.
A combination of better wear resistance and better edge line toughness gave a considerable increase in tool life.

| Results: | Tool-life: minutes in cut |
|---|---|
| Invention A: | 43 |
| Prior art B: | 17.2 |

| Operation 5: | Face milling, Coromill 300 |
|---|---|
| Work-piece: | Main fitting |
| Material: | High-alloyed steel, 330HB |
| Cutting speed: | 263 m/min |
| Feed rate/tooth: | 0.25 mm/tooth |
| Axial depth of cut: | 1.5 mm |
| Radial depth of cut: | 0-125 mm |
| Insert-style: | R245-12T3M-PH |
| Cutter diameter: | 125 mm |

Note: Eight inserts in the cutter, dry machining.

Tool-life criterion edge line toughness chipping.
A combination of better comb crack resistance and better edge line toughness gave a considerable increase in tool life.

Results:      Tool-life, minutes in cut
Invention A:        32
Prior art B:        21

Operations 1-5 in example 3 clearly show that the inserts from Example 1 outperform the prior art inserts according to Example 2.

## Claims

1. A cutting tool milling insert for machining of unalloyed, low and high alloyed steels and cast irons, with or without raw surfaces, during wet or dry conditions, **characterized in that** the cutting tool milling insert comprising:

   a cemented carbide body; and
   a coating at least partly covering the body,

   wherein said cemented carbide body has a composition of 8.1 to 9.3 wt% Co, 1.00 to 1.45 wt% TaC, 0.10 to 0.50 wt% NbC and balance WC,
   wherein a coercivity is in the range 14.9 to 16.7 kA/m, and a CW-ratio is 0.80 to <1.00,
   wherein said coating is 7.5 to 13.5 $\mu$m thick and includes at least three layers of $TiC_xN_yO_z$ with a total thickness of 3.0 to 8.0 $\mu$m, the $TiC_xN_yO_z$ layers including:

   a first $TiC_xN_yO_z$ layer adjacent to the cemented carbide body having a composition of x+y=1, x>= 0,
   a second $TiC_xN_yO_z$ layer having a composition of x>0.4, y>0.4 and 0=< z < 0.1,
   a third $TiC_xN_yO_z$ bonding layer with needle shaped grains adjacent to an $\alpha$-$Al_2O_3$-layer having a composition of x+y+z>=1 and z>0, and

   wherein the $\alpha$-$Al_2O_3$-layer is an outer layer at least on a rake face, the $\alpha$-$Al_2O_3$-layer has a thickness of 2.0 to 6.0 $\mu$m, and at least a portion of the $\alpha$-$Al_2O_3$-layer is blasted smooth with flattened grains on surfaces that have been subjected to the blasting treatment.

2. Cutting insert according to claim 1 **characterized in that** the cemented carbide has the composition 8.3-9.1 wt-% Co and 1.18-1.28 wt% TaC and 0.25-0.35 wt% NbC and balance WC, with a coercivity within 15.3-16.3 kA/m and a CW-ratio of 0.81-0.90.

3. A cutting tool insert according to claim 1 **characterized in** having a 0.1-2.3 $\mu$m coloured top layer at the flank faces.

4. A cutting tool insert according to claim 3 **characterized in that** the coloured layer consists of TiN, Ti(C,N), TiC, ZrN and/or HfN deposited by CVD- or PVD-technique.

5. A cutting tool insert according to claim 4 **characterized in that** the coloured layer is deposited using CVD-technique.

6. A cutting tool insert according to claim 1 **characterized in that** the first $TiC_xN_yO_z$ layer has a composition with x<0.2 and z=0, the second $TiC_xN_yO_z$ layer has a composition with z=0, and the third $TiC_xN_yO_z$ bonding layer has a composition with z>0.2 and x+y+z=1.

7. A method of making a cutting insert, the cutting insert including a cemented carbide body and a coating, the method comprising:

   forming the cemented carbide body by a powder metallurgical technique including wet milling of powders forming hard constituents and binder phase, compacting the milled mixture to bodies of desired shape and size, and sintering the compacted bodies,

   wherein said cemented carbide body has a composition of 8.1 to 9.3 wt% Co, 1.00 to 1.45 wt% TaC, 0.10 to 0.50 wt% NbC, and balance WC, a coercivity in the range 14.9 to 16.7 kA/m, and a CW-ratio of 0.80 to <1.00;
   coating at least a portion of the cemented carbide body with a 7.5 to 13.5 $\mu$m thick coating,

wherein the coating including an inner coating having at least three layers of $TiC_xN_yO_z$ and an outer layer having a smooth $\alpha$-$Al_2O_3$-layer at least on a rake face of the cutting insert,

wherein the $TiC_xN_yO_z$-layers have a total thickness of 3.0 to 8.0 $\mu$m,

wherein the coating comprises:

a first $TiC_xN_yO_z$ layer adjacent to the cemented carbide having a composition of x+y=1, x>= 0, deposited by a CVD method using a reaction mixture consisting of $TiCl_4$, $H_2$ and $N_2$,

a second $TiC_xN_yO_z$ layer having a composition of x>0.4, y>0.4 and 0=< z < 0.1, deposited by a MTCVD-technique at a temperature of 885-850°C and with $CH_3CN$ as the carbon/nitrogen source,

a third $TiC_xN_yO_z$ bonding layer with needle shaped grains having a composition of x+y+z>=1 and z>0, deposited by a CVD method using a reaction mixture consisting of $TiCl_4$, $H_2$ and $N_2$, the third $TiC_xN_yO_z$ bonding layer adjacent to the $\alpha$-$Al_2O_3$-layer, and

wherein the $\alpha$-$Al_2O_3$-layer has a thickness of 2.0 to 6.0 $\mu$m deposited by a CVD-technique; and

subjecting the insert to a blasting treatment at least on the rake face so that a smooth $\alpha$-$Al_2O_3$ with flattened grains is exposed.

8. Method according to claim 7 **characterized**
depositing an additional 0.1-2.3 $\mu$m coloured layer on top of the $\alpha$-$Al_2O_3$-layer preferably of TiN, Ti(C,N), TiC, ZrN or HfN.

9. Method according to claim 7 **characterized in that** the coloured layer is deposited by a CVD technique prior to the blasting treatment.

10. Method according to claim 7 **characterized** depositing, after the blasting treatment, an additional 0.1-2.3 $\mu$m coloured top layer at the flank faces.

11. Method according to claim 7 **characterized in that** the coloured layer is of TiN, Ti(C,N), TiC, ZrN or HfN.

12. Method according to claim 11 **characterized in that** the additional coloured layer is deposited by a CVD technique prior to the blasting treatment.

13. Method according to claim 7 **characterized in that** the cemented carbide body has a composition of 8.3-9.1 wt-% Co, 1.18-1.28 wt% TaC, 0.25-0.35 wt% NbC, and balance WC, with a coercivity within 15.3-16.3 kA/m and a CW-ratio of 0.81-0.90.

14. Method according to claim 7 **characterized in that** the first $TiC_xN_yO_z$ layer has a composition with x<0.2 and z=0, the second $TiC_xN_yO_z$ layer has a composition with z=0, and the third $TiC_xN_yO_z$ bonding layer has a composition with z>0.2 and x+y+z=1.

15. Use of an insert according to claims 1-6 for dry and wet milling of unalloyed, low and high alloyed steels and cast irons, with raw surfaces such as cast skin, forged skin, hot or cold rolled skin or premachined surfaces under stable conditions at cutting speeds and feed rates according to the following:

Milling with 90° entering angle:

Cutting speed: 25-400 m/min, and feed rate: 0.04-0.4 mm/tooth Face milling (45-75° entering angle):
Cutting speed: 25-600 m/min, and feed rate: 0.05-0.7 mm/tooth High feed and round insert milling concepts:
Cutting speed: 25-600 m/min and feed rate: 0.05-3.0 mm/tooth.

**Fig 1**

**Fig 2**

Fig 3

Fig 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6062776 A
- US 6406224 B
- EP 736615 A
- EP 1696051 A
- US 6200671 B
- EP 523021 A